(19) Europäisches Patentamt
European Patent Office
Office européen des brevets

(11) **EP 1 993 138 B1**

(12) **FASCICULE DE BREVET EUROPEEN**

(45) Date de publication et mention
de la délivrance du brevet:
**13.06.2012 Bulletin 2012/24**

(51) Int Cl.:
***H01L 29/786*** *(2006.01)* ***H01L 27/20*** *(2006.01)*
***H01L 21/336*** *(2006.01)*

(21) Numéro de dépôt: **08155761.3**

(22) Date de dépôt: **07.05.2008**

(54) **Dispositif à transistor à canal contraint**

Transistorvorrichtung mit verspanntem Kanal

Device with a strained-channel transistor

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **15.05.2007 FR 0755080**

(43) Date de publication de la demande:
**19.11.2008 Bulletin 2008/47**

(73) Titulaire: **Commissariat à l'Énergie Atomique et aux Énergies Alternatives**
**75015 Paris (FR)**

(72) Inventeurs:
• **Collonge, Michael**
**26100, ROMANS (FR)**
• **Vinet, Maud**
**38140, RIVES (FR)**

(74) Mandataire: **Ilgart, Jean-Christophe et al**
**BREVALEX**
**95 rue d'Amsterdam**
**75378 Paris Cedex 8 (FR)**

(56) Documents cités:
**EP-A- 1 024 540     US-A1- 2007 018 328**

## Description

### DOMAINE TECHNIQUE ET ART ANTERIEUR

L'invention concerne le domaine des circuits intégrés, et plus particulièrement celui des transistors tels que les transistors MOS.

Un moyen d'augmenter le courant $I_{ON}$, c'est-à-dire le courant de saturation à l'état passant, des dispositifs microélectroniques de type MOS consiste à mettre à profit les contraintes mécaniques induites par les procédés technologiques mis en oeuvre au cours de la fabrication des transistors pour améliorer la mobilité des porteurs de charges (trous pour les transistors PMOS et électrons pour les transistors NMOS).

Différentes méthodes ont déjà été mises au point dans le but de mettre en contrainte le canal d'un transistor.

Dans les dispositifs réalisés en technologie CMOS, des couches à base de nitrure, déposées de manière conforme à la surface de la structure d'un transistor MOS, permettent d'appliquer une contrainte uniaxiale en tension dans le canal d'un transistor NMOS et une contrainte uniaxiale en compression dans celui d'un transistor PMOS. Ces contraintes permettent d'augmenter la mobilité des porteurs et donc d'augmenter proportionnellement le courant $I_{ON}$ du transistor. Mais à l'état bloqué, ces contraintes réduisent la masse effective des porteurs, augmentant ainsi les courants de fuites par effet tunnel, notamment lorsque la longueur de grille est faible, et réduisant donc les performances du transistor à l'état « OFF » en augmentant la consommation du transistor dans cet état « OFF ».

Le document US 5 883 419 décrit un transistor MOS comportant une couche à base d'un matériau piézoélectrique disposée entre la grille et le canal du transistor. Le canal du transistor est à base de MoC un matériau métallique et piézorésistif, et est susceptible d'être contraint lors de la polarisation du matériau piézoélectrique de la grille.

Dans un tel transistor, les performances en terme de vitesse et de consommation, reposant sur un changement de résistivité du matériau du canal, et en particulier le rapport entre le courant de saturation et le courant de fuite, sont insuffisantes pour les applications de masse des transistors. De plus, la réalisation d'un tel transistor au niveau industriel s'avère onéreuse dans la mesure où le MoC est un matériau coûteux. Enfin, un tel dispositif n'est pas réalisable en technologie CMOS.

Le document FR 2 888 990 décrit un dispositif microélectronique comprenant un transistor doté d'une couche à base de matériau piézoélectrique déposée de manière conforme à la surface de la structure d'un transistor MOS, c'est-à-dire sur la grille et sur les zones de source et de drain du transistor. Le dispositif repose sur l'application d'une contrainte uniaxiale selon la direction de propagation des porteurs, dans le canal du transistor, permettant d'obtenir un courant $I_{ON}$ élevé et un courant $I_{OFF}$ faible.

Toutefois, compte tenu de la géométrie du dispositif, seuls des matériaux piézoélectriques pouvant être obtenus par dépôt peuvent être utilisés (par exemple des céramiques PZT, dont les coefficients piézoélectriques sont faibles : $d_{33} \approx 80$ pm/V et $d_{31} \approx -40$ pm/V, $d_{33}$ étant un coefficient décrivant la déformation du matériau piézoélectrique selon une direction parallèle au vecteur de polarisation de la couche piézoélectrique, c'est-à-dire la déformation en épaisseur, $d_{31}$ étant un coefficient décrivant la déformation du matériau piézoélectrique selon une direction orthogonale au vecteur de polarisation de la couche piézoélectrique, c'est-à-dire la déformation en largeur). Avec de tels matériaux piézoélectriques, la contrainte maximale pouvant être obtenue à la surface du canal est par exemple inférieure à 100 MPa pour un transistor ayant une longueur de grille égale à 40 nm et une épaisseur de la couche piézoélectrique égale à 300 nm, ce qui limite considérablement les gains en terme d'augmentation du courant $I_{ON}$ et de réduction du courant $I_{OFF}$.

De plus, dans ce type de structure, la couche piézoélectrique est polarisée par ses surfaces en contact avec, d'une part le matériau conducteur de grille, et d'autre part avec la région de source et/ou de drain du transistor. Ainsi, le champ électrique appliqué à la couche piézoélectrique est maximal dans la région située à proximité de l'oxyde de grille et est donc inhomogène dans la couche piézoélectrique. Pour ne pas détériorer le dispositif, la valeur maximale du champ électrique appliqué dans cette région doit rester inférieure à la valeur du champ de claquage du matériau piézoélectrique (par exemple, pour une couche mince à base de céramique PZT, $E_{claquage} \approx 800$ kV/cm). Pour une différence de potentiel de 1 V, le champ électrique dans la couche piézoélectrique reste inférieur à son champ de claquage pour des épaisseurs d'oxyde supérieures à 12,5 nm dans le cas d'une céramique de PZT (distance inter-électrodes mini = 1 V/800 kV.cm$^{-1}$ = 12,5 nm). Cette structure n'est donc pas adaptée pour induire une contrainte dans le canal de transistors MOS d'épaisseurs d'oxyde de grille inférieures à 10 nm.

### EXPOSÉ DE L'INVENTION

Un but de la présente invention est de proposer une nouvelle structure de transistor MOS aux performances électriques améliorées : augmentation du courant $I_{ON}$ et réduction du courant $I_{OFF}$ par rapport aux dispositifs de l'art antérieur, permettant une plus grande vitesse de fonctionnement des dispositifs et une consommation moindre à l'état OFF, et pouvant comporter un oxyde de grille dont l'épaisseur puisse être inférieure aux limites imposées par les dispositifs de l'art antérieur, par exemple inférieure à environ 10 nm.

Ce dispositif repose sur l'application d'une contrainte mécanique d'intensité variable dans le canal d'un transistor MOS, indépendamment de sa longueur de grille.

La présente invention concerne une nouvelle structure de transistor MOS dont il est possible de faire varier l'état de contrainte au sein du canal en fonction de la tension de grille. Elle repose sur l'utilisation d'une couche piézoélectrique permettant d'induire une contrainte d'amplitude variable et de direction variable dans la région du canal d'un transistor MOS.

Pour cela, la présente invention propose un dispositif semi-conducteur comportant au moins :

- un substrat,
- un transistor comprenant au moins une région de source, une région de drain, un canal et une grille,
- une couche à base d'au moins un matériau piézoélectrique, reposant au moins sur la grille et apte à induire au moins une contrainte mécanique sur le canal du transistor selon une direction sensiblement perpendiculaire au plan d'une face de la couche piézoélectrique se trouvant du côté de la grille,

la couche piézoélectrique étant disposée entre deux électrodes de polarisation, l'une des deux électrodes de polarisation étant formée par une première couche à base d'au moins un matériau électriquement conducteur tel que la couche piézoélectrique soit disposée entre cette première couche conductrice et la grille du transistor.

Contrairement à certains dispositifs de l'art antérieur dans lesquels la grille réduit la transmission des déformations générées au sein de la couche piézoélectrique, la couche piézoélectrique, qui peut être plane, est placée sur la face supérieure de la grille du transistor, sans être directement disposée sur les zones de source et de drain. On tire ainsi profit de la présence de la grille pour transmettre les déformations générées au sein de la couche piézoélectrique jusqu'au canal, permettant d'obtenir des contraintes supérieures à 100 MPa dans le canal.

La couche piézoélectrique est polarisée grâce aux deux électrodes entre lesquelles se trouve ladite couche piézoélectrique, une électrode étant formée sur la couche piézoélectrique, indépendamment des dimensions de la structure MOS elle-même. L'invention peut donc s'appliquer pour des longueurs de grille et des épaisseurs d'oxyde de grille très faibles, pouvant être respectivement égales à environ 10 nm et de 0,5 nm.

La planarisation de la surface de la structure du transistor MOS formée notamment par la face supérieure de la grille, et le fait la couche piézoélectrique ne soit pas déposée sur les zones de source et de drain, permet, en plus de l'utilisation de matériaux piézoélectriques obtenus par dépôt tels que les céramiques PZT pour former la couche piézoélectrique, d'utiliser des matériaux piézoélectriques monocristallins en couches minces reportées par collage. Ceci élargit le choix des matériaux piézoélectriques pour la réalisation de la structure. De plus, certains matériaux piézoélectriques monocristallins présentent des coefficients piézoélectriques très élevés, à l'exemple du PMN-PT et/ou du PZN-PT ($d_{33}$(PMN-PT)

$\approx 2404$ pm/V). L'utilisation de matériaux piézoélectriques à coefficients piézoélectriques très élevés présente l'avantage d'accroître les niveaux de contrainte obtenus au niveau du canal, et ainsi d'augmenter les performances du transistor.

L'utilisation d'une couche piézoélectrique comme générateur de déformations permet d'induire au sein du canal un état de contrainte de direction et d'amplitude variables, contrôlées respectivement par le signe et la valeur de la polarisation appliquée aux bornes de la couche piézoélectrique, qui avantageusement peut être la même que celle appliquée sur la grille. La tension destinée à être appliquée à la grille du transistor peut être similaire à la tension destinée à être appliquée à la couche piézoélectrique.

La couche piézoélectrique et/ou la première couche conductrice peuvent être planes.

Les dimensions des faces des électrodes en contact avec la couche piézoélectrique peuvent être supérieures ou égales aux dimensions des faces de la couche piézoélectrique en contact avec les électrodes. Ainsi, le champ électrique créé par la tension appliquée sur les électrodes de polarisation, entre lesquelles se trouve la couche piézoélectrique, est uniforme dans toute la couche piézoélectrique. Ce champ électrique uniforme implique une contrainte uniforme appliquée ensuite dans tout le canal par la couche piézoélectrique.

Dans une première variante, l'autre des deux électrodes de polarisation peut être formée par la grille du transistor.

Dans une seconde variante, l'autre des deux électrodes de polarisation peut être formée par une seconde couche à base d'au moins un matériau électriquement conducteur disposée entre la couche piézoélectrique et la grille du transistor.

Dans ce cas, le dispositif peut comporter en outre une couche diélectrique disposée entre la grille et la seconde couche à base de matériau conducteur. Cette couche diélectrique permet d'isoler l'électrode de polarisation, formée par la seconde couche conductrice, de la grille du transistor, permettant ainsi une commande indépendante du transistor (par l'intermédiaire de la grille) et de la couche piézoélectrique (par l'intermédiaire des électrodes de polarisation).

La première couche conductrice et/ou, lorsque le dispositif comporte une seconde couche conductrice, la seconde couche conductrice peuvent être sensiblement planes et parallèles à la couche piézoélectrique.

Dans le dispositif selon l'invention, la rigidité de l'empilement de grille peut être mise à profit : elle peut participer à la transmission de la déformation générée par la couche piézoélectrique jusqu'à la surface du canal. En effet, lorsque la longueur de grille $L_g$ du transistor est réduite, l'homme de métier tend à remplacer une grille peu rigide, par exemple à base de polysilicium, par une grille métallique plus rigide, par exemple à base de TiN (E(TiN) $\approx 290$ GPa, et E(Si) $\approx 130$ GPa, avec E coefficient de raideur du matériau ou module d'Young). Cette rigidité peut être très néfaste dans le cas où la couche piézoélectrique est déposée de manière conforme sur la surface du transistor (sur la grille et sur les zones de source et de drain), comme décrit dans le document FR 2 888 990, car elle va à l'encontre de la transmission des déformations. Dans le dispositif selon l'invention, la déformation est générée par la couche piézoélectrique essentiellement selon une direction sensiblement perpendiculaire au plan dans lequel se trouve la face de la couche piézoélectrique se trouvant du côté de la grille. La contrainte induite est donc une contrainte uniaxiale selon cette direction, équivalente, au niveau de la zone de canal, à une contrainte biaxiale dans un plan parallèle au plan de la face de la couche piézoélectrique se trouvant du côté de la grille. L'impact de la grille sur la transmission des déformations est différent. Dans le cas d'une déformation transmise selon la direction sensiblement perpendiculaire au plan dans lequel se trouve la face de la couche piézoélectrique se trouvant du côté de la grille, comme c'est le cas pour l'invention, la rigidité de la grille permet de déformer plus fortement le canal situé sous l'empilement de grille, tandis que dans le cas d'une déformation transmise selon une direction se trouvant dans ledit plan de ladite face de la couche piézoélectrique, comme c'est le cas pour le dispositif décrit dans FR 2 888 990, la rigidité de la grille réduit la déformation du canal.

La rigidité des couches conductrices formant des électrodes peut également être mise à profit : d'après la direction des déformations selon un axe sensiblement perpendiculaire au plan de la face de la couche piézoélectrique se trouvant du côté de la grille, elles participent, de manière analogue à la grille, à la transmission des déformations générées dans la couche piézoélectrique à la grille. La ou les couches conductrices peuvent être à base de molybdène et/ou de platine. Dans le cas d'une couche piézoélectrique déposée de façon conforme à la surface du transistor et polarisée par des électrodes horizontales, ces électrodes, à base d'un matériau, par exemple du molybdène ou du platine, très rigide par rapport au silicium du canal ($E(Mo) \approx 320$ GPa, $E(Pt) \approx 276$ GPa alors que $E(Si) \approx 130$ MPa) fixent toute la surface du transistor. L'électrode inférieure agit ainsi comme une barrière à la transmission de déformations générées selon une direction dans le plan de la face de la couche piézoélectrique se trouvant du côté de la grille. Elle concentre en son sein les déformations, celles-ci n'étant que très faiblement transmises à la surface du canal. Il est ainsi difficile d'induire des contraintes au sein du canal.

Grâce à la structure selon l'invention, la contrainte induite peut être localisée sous la grille, et plus précisément à proximité d'une interface diélectrique de grille/substrat qui correspond à la zone d'inversion du canal selon le mode de fonctionnement d'un transistor MOS. Il s'agit de la zone de transport des porteurs et donc celle où la contrainte peut être le plus fortement appliquée afin de profiter au maximum de ses effets sur les performances électriques du transistor.

Lorsque l'électrode inférieure de polarisation du matériau piézoélectrique, c'est-à-dire la couche conductrice se trouvant entre la couche piézoélectrique et le substrat, est en contact avec la grille sur toute la largeur de celle-ci (la largeur correspondant à la direction transverse au canal), la résistivité de la grille peut être réduite, ce qui implique que le temps de polarisation de la grille sur toute sa largeur, et donc le temps de fonctionnement du transistor, peut être réduit.

La structure du dispositif favorise également son fonctionnement mécanique et correspond à un procédé technologique standard de fabrication d'un transistor MOS.

Le dispositif semi-conducteur peut comporter en outre au moins une portion à base d'au moins un matériau diélectrique disposée sur le substrat et à côté de la grille, recouvrant au moins une partie de la zone de source ou de drain, la couche piézoélectrique reposant également sur cette portion diélectrique.

Le dispositif semi-conducteur peut comporter en outre une seconde portion d'au moins un matériau diélectrique disposée sur le substrat et à côté de la grille, sur laquelle peut reposer la couche piézoélectrique, les zones de source et de drain pouvant être au moins recouvertes en partie par les portions diélectriques.

Le dispositif selon l'invention tire avantageusement profit de la ou des portions diélectriques, par exemple à base de $SiO_2$, de part et d'autre de la grille car le $SiO_2$ est un matériau mécaniquement peu rigide. Ainsi, le mode de déformation longitudinale de la couche piézoélectrique est favorisé car ses bords verticaux sont libres de se déformer le plus possible.

Par ailleurs, avantageusement, la surface supérieure de la couche piézoélectrique peut être fixée le plus rigidement possible afin que les déformations soient transmises de préférence vers le bas, du côté du transistor et non pas aux matériaux situés au-dessus de la couche piézoélectrique. Cette condition peut être obtenue intrinsèquement lorsque les niveaux d'interconnexions sont nombreux (ce qui est le cas dans les circuits complexes comportant jusqu'à 10 niveaux de métal) et peut être favorisée expérimentalement par le dépôt d'une couche servant d'électrode supérieure constituée d'un matériau très rigide, par exemple du platine ou du molybdène.

Enfin, ce dispositif tire avantageusement profit du mode de déformation longitudinale du matériau piézoélectrique ce qui constitue un avantage en terme de procédé par rapport à la réalisation d'électrodes verticales qui peuvent être utilisées avantageusement pour profiter du mode de déformation transversal du matériau piézoélectrique. En effet, le dimensionnement des électrodes est mieux maîtrisé dans le cas d'électrodes horizontales, c'est-à-dire dans le plan de la face de la couche piézoélectrique se trouvant du côté de la grille, formées par une couche mince conductrice qui peut être obtenue par dépôt, croissance, report..., que dans le cas d'électrodes verticales posant des problèmes lors de la gravure verticale du matériau constituant les électrodes.

Le dispositif semi-conducteur peut comporter en outre une couche diélectrique disposée entre la grille et la couche piézoélectrique.

Le transistor peut être avantageusement de type MOS.

Le substrat peut comporter une couche à base d'un matériau semi-conducteur, sur laquelle sont empilées une couche diélectrique et une couche active à base d'un matériau semi-conducteur.

Le substrat peut comporter une cavité formée au moins sous le canal du transistor.

La cavité peut être remplie d'au moins un matériau dont la raideur peut être inférieure à celle du matériau du substrat.

La grille peut être à base de polysilicium et/ou de nitrure de titane et/ou de nitrure de tantale.

La raideur du matériau de la grille peut être supérieure à la raideur du matériau de la ou des portions diélectriques.

Le rapport de la raideur du matériau de la grille sur la raideur du matériau de la ou des portions diélectriques peut être supérieur à 1, et par exemple compris entre environ 2 et 5.

Lorsque la couche piézoélectrique est disposée entre deux couches conductrices, la raideur du matériau des couches conductrices peut être supérieure à la raideur du matériau des portions diélectriques.

La couche piézoélectrique peut être symétrique par rapport à un premier plan sensiblement perpendiculaire au plan de la face de la couche piézoélectrique se trouvant du côté de la grille, la grille pouvant être symétrique par rapport à un second plan sensiblement perpendiculaire audit plan de la face de la couche piézoélectrique se trouvant du côté de la grille, les premier et second plans pouvant être superposés ou décalés l'un par rapport à l'autre.

La présente invention concerne également un procédé de réalisation d'un dispositif semi-conducteur comportant au moins les étapes de :

-   réalisation d'un transistor comprenant au moins une région de source, une région de drain, un canal et une grille sur un substrat,
-   dépôt d'une couche à base d'au moins un matériau piézoélectrique au moins au-dessus de la grille, la couche piézoélectrique étant apte à induire au moins une contrainte mécanique sur le canal du transistor selon une direction perpendiculaire au plan d'une face de la couche piézoélectrique se trouvant du côté de la grille,
-   dépôt d'une couche à base d'au moins un matériau électriquement conducteur formant une première électrode de polarisation tel que la couche piézoélectrique soit disposée entre cette couche conductrice et la grille du transistor,

la couche piézoélectrique étant également disposée sur une seconde électrode de polarisation.

Le procédé peut comporter en outre, entre l'étape de réalisation du transistor et l'étape de dépôt de la couche piézoélectrique, une étape de dépôt d'une autre couche à base d'au moins un matériau électriquement conducteur au moins au-dessus de la grille, la couche piézoélectrique pouvant être ensuite déposée sur cette autre couche conductrice formant la seconde électrode de polarisation.

Le procédé peut également comporter, avant l'étape de dépôt de l'autre couche à base de matériau électriquement conducteur, une étape de dépôt d'une couche diélectrique sur la grille, ladite autre couche à base de matériau électriquement conducteur étant déposée sur la couche diélectrique.

Dans une autre variante, le procédé peut comporter en outre, entre l'étape de réalisation du transistor et l'étape de dépôt de la couche piézoélectrique, une étape de réalisation de la couche piézoélectrique et d'une autre couche à base d'au moins un matériau électriquement conducteur par implantation ionique dans un substrat à base du matériau piézoélectrique comportant ladite autre couche conductrice sur une de ses faces, et par fracture au niveau de l'implantation réalisée dans le substrat, ladite autre couche conductrice pouvant être disposée contre la grille lors de l'étape de dépôt de la couche piézoélectrique.

Le procédé peut comporter en outre, avant l'étape de réalisation du transistor, une étape de réalisation d'une cavité dans le substrat, destinée à être disposée sous le canal du transistor.

La réalisation de la cavité peut être obtenue par la mise en oeuvre des étapes suivantes :

-   dépôt d'une première couche sur le substrat et d'une seconde couche, à base d'un matériau similaire à celui du substrat, sur la première couche, la première couche étant à base d'un matériau pouvant être gravé sélectivement par rapport aux matériaux du substrat et de la seconde couche,
-   gravure anisotrope des premières et secondes couches telles que le motif formé par la portion restante de la première couche soit sensiblement similaire au motif de la cavité, avec arrêt au niveau du substrat,
-   épitaxie du matériau du substrat tel que le substrat et la seconde couche forme une couche active du substrat encapsulant la portion restante de la première couche,
-   réalisation d'une ouverture dans la couche active pour accéder à la portion restante de la première couche,
-   gravure sélective du matériau de la portion restante de la première couche, formant la cavité.

Le procédé peut comporter en outre, lorsque le substrat est du type semi-conducteur sur isolant, après l'étape de gravure sélective du matériau de la portion restante de la première couche, les étapes supplémentaires de :

- oxydation des parois de la cavité,
- gravure sélective de l'oxyde formée au niveau des parois tel qu'une partie de l'isolant du substrat forme une paroi de la cavité.

Le procédé peut comporter en outre, après la réalisation de la cavité, une étape de remplissage de la cavité par au moins un matériau dont la raideur est inférieure à celle du matériau du substrat.

Le procédé peut comporter en outre, entre l'étape de réalisation du transistor et l'étape de dépôt de la couche piézoélectrique, une étape de dépôt d'au moins une portion à base d'au moins un matériau diélectrique sur le substrat, pouvant recouvrir au moins une partie de la zone de source ou de drain, à côté de la grille, la couche piézoélectrique pouvant être ensuite déposée au-dessus de la portion diélectrique.

Le procédé peut comporter en outre, entre l'étape de réalisation du transistor et l'étape de dépôt de la couche piézoélectrique, une étape de dépôt d'au moins une portion à base d'une résine, et une étape de retrait de cette portion de résine après le dépôt de la couche piézoélectrique au-dessus de la grille et de la portion de résine.

BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1 à 3 représentent des dispositifs semi-conducteurs à transistor à canal contraint, objets de la présente invention, respectivement selon un premier, second et troisième mode de réalisation,
- les figures 4A à 4O représentent les étapes d'un procédé de réalisation d'un dispositif semi-conducteur à transistor à canal contraint, également objet de la présente invention, selon un premier mode de réalisation,
- les figures 5A à 5D représentent des étapes d'un procédé de réalisation d'un dispositif semi-conducteur à transistor à canal contraint de manière variable, également objet de la présente invention, selon un second mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

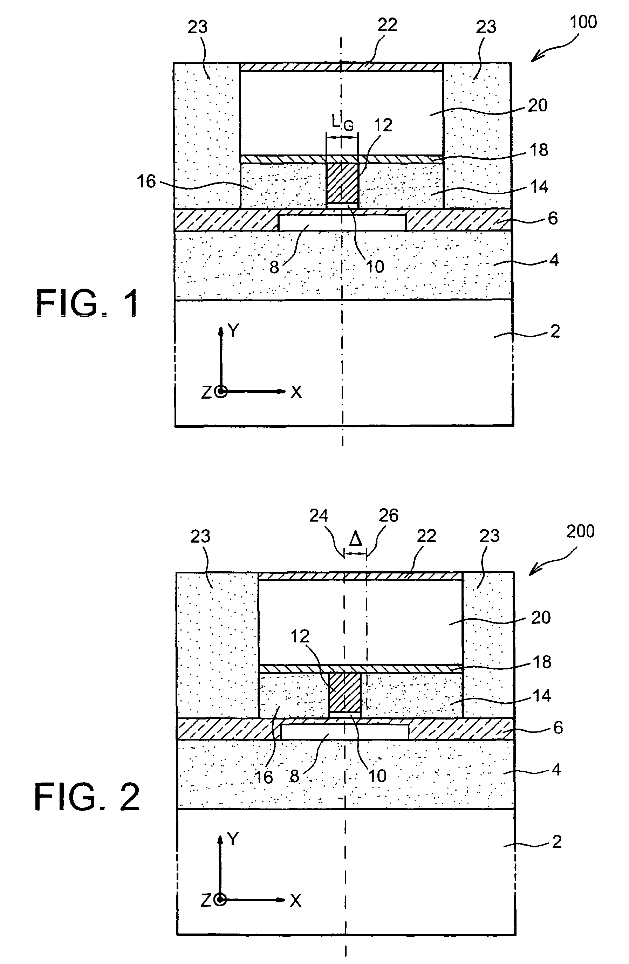

On se réfère tout d'abord à la figure 1 qui représente un dispositif semi-conducteur 100 comportant un transistor MOS à canal contraint en technologie SOI (silicium sur isolant).

Le dispositif 100 comporte un substrat 2 à base d'un matériau semi-conducteur, ici du silicium monocristallin. Une couche diélectrique 4, par exemple à base de $SiO_2$, recouvre le substrat 2, et est elle-même recouverte par une couche semi-conductrice 6 apte à jouer le rôle de couche active et par exemple à base de silicium. Le substrat 2 et les couches 4 et 6 forment un substrat de type semi-conducteur sur isolant, ici SOI (silicium sur isolant) sur lequel est réalisé un transistor MOS. La couche active 6 peut également être à base de Si, et/ou de Ge, et/ou de SiGe, et/ou GaAs. Une partie de la face de la couche active 6 se trouvant du côté de la couche diélectrique 4 est amincie, en son milieu, sur une longueur inférieure à $L_1$, $L_1$ étant la dimension des couches 2, 4 et 6 selon l'axe x représenté sur la figure 1. Cet amincissement forme donc une cavité 8 laissée ici vide (sans matériau à l'intérieur) de façon à maximiser ultérieurement la relaxation du canal du transistor du dispositif 100 par sa surface inférieure.

La couche active 6 est recouverte d'un diélectrique de grille 10 surmonté d'une grille 12 du transistor MOS. Le transistor MOS comporte également des zones de source et de drain, et un canal, non représentés sur la figure 1, réalisés dans la couche active 6. Le diélectrique de grille 10 est disposé au-dessus du canal. De plus, le canal est réalisé au-dessus de la cavité 8. Le diélectrique de grille 10 est par exemple à base de $SiO_2$ et/ou d'un matériau à forte permittivité, par exemple du $HfO_2$. Le matériau de la grille 12 est un conducteur, par exemple du silicium polycristallin, et/ou du métal tel que du TiN et/ou du TaN, et/ou une bicouche composée d'une couche de métal recouverte de polysilicium. La dimension $L_G$ du diélectrique de grille 10 et de la grille 12 selon l'axe x correspond à la longueur de grille du transistor.

De part et d'autre de cet empilement de grille sont déposées des portions diélectriques 14 et 16, par exemple à base de $SiO_2$. Ces portions diélectriques 14 et 16 ont une épaisseur égale à la somme des épaisseurs du diélectrique de grille 10 et de la grille 12. Le matériau de la grille 12 a ici une raideur supérieure à celle du matériau des portions diélectriques 14 et 16. Par exemple, lorsque la grille 12 est à base silicium polycristallin, la raideur, notée E(Si polycristallin) est égale à environ 130 GPa, et lorsque la grille 12 est à base de TiN, alors E (TiN) est égale à environ 290 GPa. Lorsque les portions diélectriques 14 et 16 sont à base de $SiO_2$, alors $E(SiO_2)$ est égale à environ 66 GPa. Le rapport de raideurs obtenu

tenu $\dfrac{E(grille)}{E(portions\ diélectriques)}$ est donc par

exemple compris entre environ 2 et 5.

La grille 12 et les portions diélectriques 14 et 16 ont leurs faces supérieures, c'est-à-dire la face opposée à celle se trouvant en contact avec la couche active 6 pour les portions diélectriques 14 et 16 et une face opposée à celle se trouvant en contact avec le diélectrique de grille 10 pour la grille 12, situées à un même niveau, c'est-à-dire se trouvant dans un même plan.

La grille 12 et les portions diélectriques 14 et 16 sont recouvertes d'un empilement de trois couches : une première couche conductrice 18, une couche 20 à base d'un matériau piézoélectrique et une seconde couche conductrice 22. Les couches conductrices 18 et 22 servent d'électrodes, respectivement inférieure et supérieure, de polarisation du matériau piézoélectrique de la couche 20. Le matériau des couches conductrices 18 et 22 peut être par exemple du molybdène et/ou du platine, le choix de ce matériau dépendant de la nature du matériau piézoélectrique utilisé dans la couche 20. De plus, la raideur du matériau des couches conductrices 18 et 22 est ici choisie supérieure à celle du matériau diélectrique des portions diélectriques 14 et 16. On a par exemple $E(Mo) \approx 320$ GPa, $E(Pt) \approx 276$ GPa pour les couches 18 et 22 et $E(SiO_2) \approx 66$ GPa pour les portions diélectriques 14 et 16. Le matériau piézoélectrique de la couche 20 peut être par exemple un matériau à fort coefficient piézoélectrique tel du PMN-PT et/ou du PZN-PT.

Les couches 18, 20 et 22, ainsi que l'ensemble comportant le diélectrique de grille 10, la grille 12 et les portions diélectriques 14 et 16, ont, selon l'axe x représenté sur la figure 1, une même longueur $L_2$ inférieure à $L_1$. De plus, la couche piézoélectrique 20 et les couches conductrices 18 et 22 sont centrées par rapport à l'axe, ou plan, de symétrie du transistor MOS passant au milieu de la grille 12, entre les zones de source et de drain. De part et d'autre de l'empilement formé des couches 18, 20 et 22, du diélectrique de grille 10, de la grille 12 et des portions diélectriques 14 et 16, on dépose sur la couche active 6 des portions 23 à base d'un matériau diélectrique, par exemple du $SiO_2$.

Selon le principe de l'effet piézoélectrique inverse, lorsqu'on soumet un matériau piézoélectrique à un champ électrique extérieur, celui-ci se déforme. Pour déformer le matériau piézoélectrique de la couche 20, on applique une différence de potentiel entre ses deux électrodes 18 et 22, polarisant ainsi la couche piézoélectrique. Dans le dispositif 100, la grille 12 est en contact avec l'électrode inférieure 18. L'électrode supérieure 22 est reliée électriquement à la source du transistor. La polarisation de la couche piézoélectrique 20 est donc liée au fonctionnement du transistor MOS. La déformation du matériau piézoélectrique 20 est ainsi asservie sur la tension de grille du transistor. La couche piézoélectrique 20 s'étend ou se comprime, en fonction du signe de la polarisation de la grille 12, principalement selon la direction de l'axe y représenté sur la figure 1, d'après la configuration de l'empilement couche piézoélectrique 20/électrodes de polarisation horizontales 18 et 22. Les déformations générées selon l'axe y au sein de la couche piézoélectrique 20 se transmettent dans toute la structure du dispositif 100. La couche active 6, et donc le canal du transistor, est ainsi mise en contrainte de manière biaxiale dans le plan perpendiculaire à l'axe y, c'est-à-dire un plan parallèle au plan (x,z).

L'effet piézoélectrique obtenu est d'autant plus élevé que la surface de la couche piézoélectrique en regard des électrodes de polarisation est grande. Afin d'obtenir dans le canal du transistor une contrainte d'amplitude intéressante en terme de gain en performances électriques du dispositif, l'effet piézoélectrique généré par la couche piézoélectrique doit être suffisant. Avantageusement, l'ensemble constitué de la couche piézoélectrique et de ses électrodes de polarisation a une longueur adaptée en fonction des caractéristiques électromécaniques du matériau de la couche piézoélectrique. Sur l'exemple de la figure 1, l'électrode supérieure 22 a une longueur selon l'axe X égale à la longueur de la couche piézoélectrique 20. De plus, dans cet exemple de réalisation, la longueur de la couche piézoélectrique est supérieure à $L_G$. Compte tenu de cette différence de longueur, la présence de l'électrode inférieure 18 permet de polariser la couche piézoélectrique 20 sur toute sa longueur.

Dans une variante de réalisation, si la longueur, selon l'axe X représenté sur la figure 1, de la couche piézoélectrique 20, qui est égale à la longueur de l'électrode supérieure 22, est inférieure à $L_G$, le dispositif 100 peut ne pas comporter d'électrode inférieure 18. Dans ce cas, la couche piézoélectrique 20 est disposée directement sur la grille 12 qui joue le rôle d'électrode inférieure de polarisation de la couche piézoélectrique 20. La couche piézoélectrique 20 est ainsi polarisée sur toute sa longueur.

Cette contrainte appliquée permet d'augmenter le courant $I_{ON}$ et de réduire le courant $I_{OFF}$ du transistor MOS. L'influence de la contrainte sur la valeur des courants dépend du type de porteurs mis en jeu, électrons ou trous. Dans le cas d'un transistor NMOS, dans lequel les porteurs de charge sont des électrons, à l'état passant, c'est-à-dire lorsque la tension de grille $V_G$ est positive et non nulle, par exemple égale à environ 1 V, la couche piézoélectrique 20 se comprime selon la direction y et met en tension biaxiale le canal du transistor. La mobilité des porteurs et donc le courant $I_{ON}$ sont ainsi augmentés. A l'état bloqué, c'est-à-dire lorsque la tension de grille $V_G$ est nulle, la couche piézoélectrique 20 s'étend selon la direction y et met en compression biaxiale le canal du transistor. La mobilité des porteurs et donc le courant $I_{OFF}$ sont ainsi réduits.

Dans le cas d'un transistor PMOS dans lequel les porteurs de charge sont des trous, une mise en compression du canal entraîne une augmentation du courant $I_{ON}$ à l'état passant et, une mise en tension du canal entraîne une réduction du courant de fuite à l'état bloqué.

Afin d'éliminer les phénomènes parasites liés à la cavité 8, par exemple les effets d'échauffement thermique ou la concentration d'impuretés sur les différents bords de cette cavité 8, la cavité 8 peut être remplie par un matériau dont la raideur est inférieure à celle du matériau de la couche active 6, présentant ainsi de meilleures propriétés que le vide pour les différents phénomènes parasites exposés précédemment. Ce matériau peut être par exemple du $SiO_2$, et/ou un matériau poreux et/ou un matériau SOG («Spin-On-Glass » en anglais).

Dans une autre variante, la grille 12 du dispositif 100 peut être isolée de l'électrode inférieure 18 par une couche diélectrique. En isolant l'électrode inférieure 18 de la grille 12, il est possible de commander l'état de contrainte de la couche piézoélectrique 20, et donc celui de la couche active 6, indépendamment du fonctionnement du transistor MOS. Le dispositif présente alors quatre modes de fonctionnement qui diffèrent par les performances électriques du dispositif :

- courant $I_{ON}$ augmenté et courant $I_{OFF}$ réduit,
- courant $I_{ON}$ augmenté et courant $I_{OFF}$ inchangé,
- courant $I_{ON}$ inchangé et courant $I_{OFF}$ réduit,
- courant $I_{ON}$ et courant $I_{OFF}$ inchangés.

Cette possibilité de commander les performances du dispositif indépendamment du fonctionnement du transistor MOS est particulièrement avantageuse lorsque le dispositif semi-conducteur comporte plusieurs transistors, permettant par exemple d'augmenter les courants de fuite dans une certaine branche d'un circuit et de les réduire dans une autre.

On se réfère maintenant à la figure 2 qui représente un dispositif semi-conducteur 200 comportant un transistor MOS à canal contraint selon un second mode de réalisation.

Par rapport au dispositif 100 du premier mode de réalisation, la couche piézoélectrique 20 ainsi que les couches conductrices 18 et 22 sont décentrées par rapport à un axe de symétrie 24, ou un plan de symétrie, du transistor MOS. Sur la figure 2, on voit qu'un axe de symétrie 26, ou un plan de symétrie, des couches 18, 20 et 22 est décentré d'une distance Δ par rapport à l'axe de symétrie 24, ou plan de symétrie, du transistor MOS. Selon l'orientation de l'axe x représenté sur la figure 2, la distance Δ peut être prise positive ou négative par rapport à l'axe de symétrie 24 du transistor MOS, c'est-à-dire que les couches 18, 20 et 22 peuvent être décentrées aussi bien d'un côté que de l'autre par rapport au transistor MOS. Ce désalignement permet de positionner l'empilement piézoélectrique formé des couches 18, 20 et 22 de manière à maximiser la transmission des déformations de la couche piézoélectrique 20 à la couche active 6. En effet, l'anisotropie de raideur de certains matériaux piézoélectriques (par exemple, le PMN-PT) induit un champ de déformation non uniforme en leur sein. Le désalignement de l'empilement piézoélectrique permet de placer la grille 12 de telle sorte que les contraintes soient les plus élevées et les plus homogènes possible dans le canal du transistor. Ce désalignement implique également que les portions diélectriques 14 et 16 ne sont pas de la même longueur (dimension selon l'axe x représenté sur la figure 2), la portion diélectrique 14 ayant une longueur supérieure à celle de la portion diélectrique 16 sur l'exemple de la figure 2.

A l'aide d'un logiciel de simulation mécanique, les effets du désalignement peuvent être quantifiés en utilisant la distance Δ comme une variable. Un exemple est donné dans le cas où le matériau piézoélectrique est du PMN-PT monocristallin et avec les paramètres suivants :

- $L_1$ = 600 nm,
- épaisseur de la grille 12 = 50 nm,
- $L_G$ = 40 nm,
- épaisseur du diélectrique de grille 10 = 3 nm,
- épaisseur de la couche piézoélectrique 20 = 100 nm,
- $L_2$ = 300 nm,
- épaisseur des couches conductrices 18 et 22 = 10 nm,
- épaisseur de la couche active 6 = 40 nm,
- épaisseur de la cavité 8 remplie de $SiO_2$ = 30 nm,
- épaisseur de la couche diélectrique 4 = 140 nm,
- épaisseur du substrat 2 = 600 nm.

Pour de telles dimensions, le niveau de contrainte enregistré à la surface du canal dans la région située sous l'empilement de grille varie entre 402 MPa et 519 MPa, soit une variation de contrainte de 117 MPa dans le cas d'un désalignement nul (Δ=0), et entre 396 et 503 MPa, soit une variation de 107 MPa dans le cas d'un désalignement Δ = 10 nm, minimisant ainsi le caractère inhomogène de la contrainte au sein du canal.

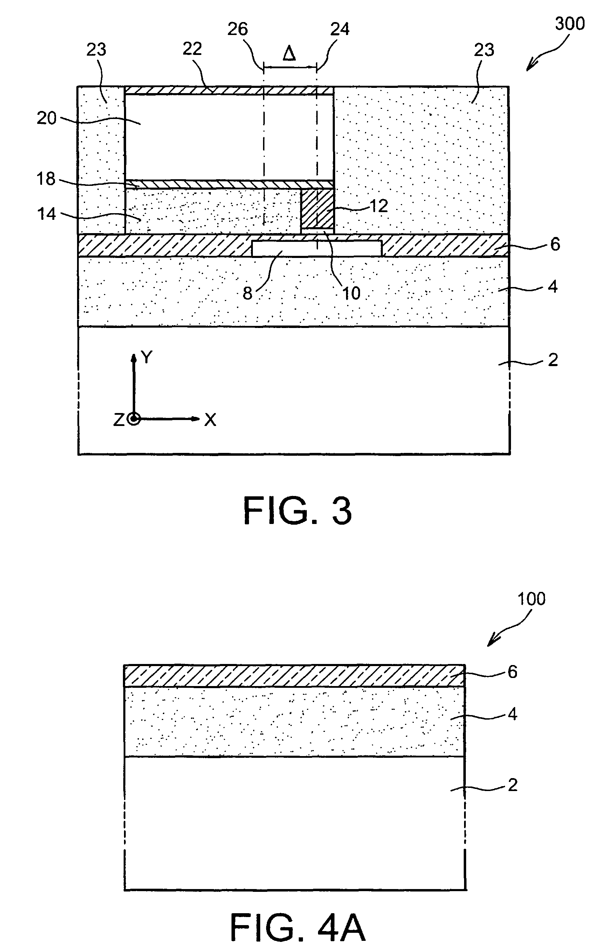

On se réfère maintenant à la figure 3 qui représente un dispositif semi-conducteur 300 comportant un transistor MOS à canal contraint de manière variable selon un troisième mode de réalisation.

L'ensemble des couches 18, 20 et 22 est ici en contact avec la face supérieure de la grille 12 mais ne surmonte que la région de source du transistor se trouvant dans cet exemple du côté gauche de l'empilement de grille. Cet agencement dissymétrique de l'empilement piézoélectrique des couches 18, 20 et 22 par rapport à la grille 12 du transistor peut être utilisé pour déformer le canal du transistor en cisaillement. La contrainte au sein du canal sera alors très inhomogène. De plus, dans ce cas, seule une portion diélectrique, ici la portion diélectrique 14, est disposée à côté de l'empilement de grille.

De même, il est possible de placer l'empilement piézoélectrique de manière à ce qu'il soit à côté de la grille 12 mais qu'il ne surmonte que la région de drain du transistor. Les effets sur le canal seront de même nature.

A l'aide d'un logiciel de simulation mécanique, les effets du désalignement peuvent être quantifiés en incrémentant la distance Δ, représentant la distance séparant l'axe de symétrie 24 du transistor et l'axe de symétrie 26 de l'empilement piézoélectrique, Δ étant, dans ce troisième mode de réalisation, égale à environ une demi-longueur de la couche piézoélectrique 20, d'une simulation à la suivante. Par exemple, dans le cas où le matériau piézoélectrique est du PMN-PT monocristallin et que les dimensions sont similaires à celles de l'exemple simulé précédemment en rapport avec la figure 2, le niveau de contrainte enregistré à la surface du canal dans la région située sous l'empilement de grille varie entre environ -40 MPa et +95 MPa dans le cas d'un désalignement nul ($\Delta$=0), et entre environ 70 MPa et 287 MPa dans le cas d'un désalignement $\Delta$ = 130 nm. D'après ces résultats, sans désalignement, le canal est d'un côté en compression et de l'autre en tension. L'introduction d'un désalignement égal à environ 130 nm permet ici d'obtenir un état de contrainte unique dans le canal (la contrainte est toujours positive).

Dans tous les modes de réalisations décrits précédemment, la surface de la structure du transistor MOS formée par les faces supérieures de la grille 12 et de la ou des portions isolantes 14, 16, étant plane, il est possible, en plus de l'utilisation de matériaux piézoélectriques obtenus par dépôt pour former la couche piézoélectrique 20, d'utiliser des matériaux piézoélectriques monocristallins en couches minces reportées par collage. Ceci élargit le choix des matériaux piézoélectriques pour la réalisation de la structure. De plus, certains matériaux piézoélectriques monocristallins présentent des coefficients piézoélectriques très élevés, à l'exemple du PMN-PT et du PZN-PT ($d_{33}$(PMN-PT) $\approx$ 2404 pm/V, en comparaison des films minces obtenus par dépôt : $d_{33}$ (films minces céramiques de PZT) $\approx$ 80).

Un procédé de réalisation du dispositif semi-conducteur 100 selon un premier mode de réalisation va maintenant être décrit en liaison avec les figures 4A à 4O.

Comme représenté sur la figure 4A, on forme tout d'abord un substrat SOI à partir du substrat 2, de la couche diélectrique 4, et d'une couche active semi-conductrice 6 ici à base de silicium, par exemple d'une épaisseur égale à environ 5 nm.

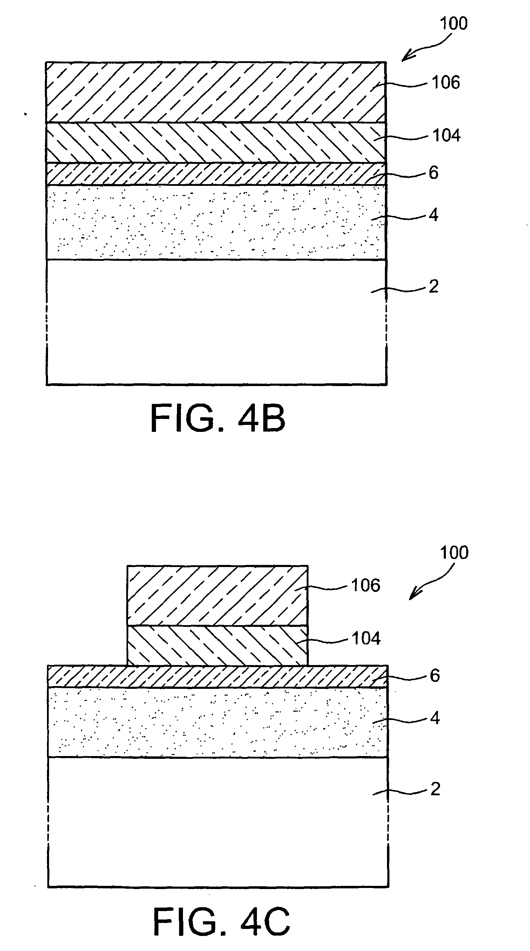

On dépose ensuite successivement, sur la couche active 6, une couche 104 puis une couche 106. Ici, le matériau de la couche 106 est similaire à celui de la couche active 6 (figure 4B). Le matériau de la couche 104 est choisi tel qu'il puisse être gravé sélectivement par rapport au matériau des couches 6 et 106, par exemple du SiGe. L'épaisseur de la couche 104 est par exemple égale à environ 20 nm, celle de la couche 106 étant par exemple égale à environ 15 nm.

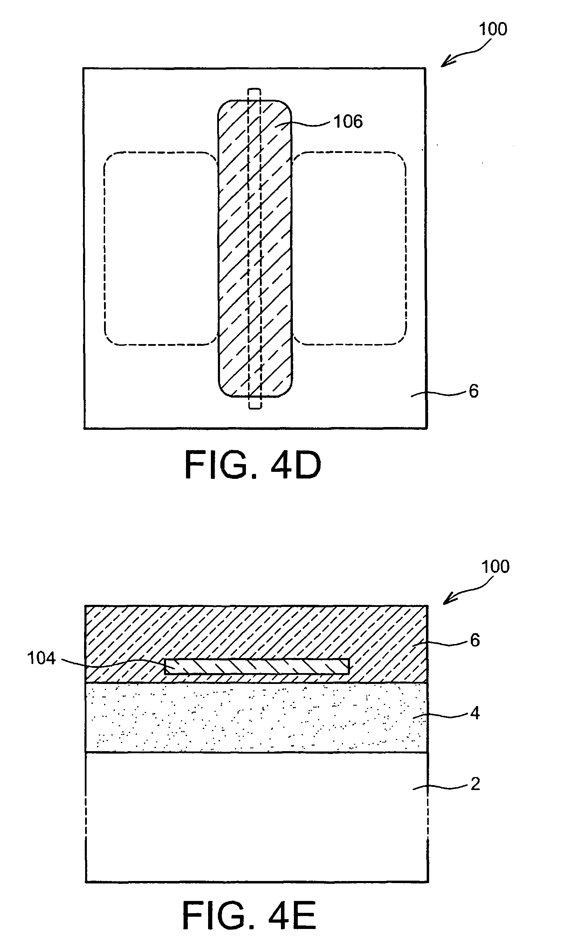

On réalise ensuite une gravure anisotrope verticale des couches 104 et 106, de manière à former des portions des couches 104 et 106 dont la forme soit sensiblement similaire à celle de la cavité 8 destinée à être formée dans le dispositif 100, mais de dimensions un peu inférieures à celles de la future cavité 8 (figures 4C et 4D, la figure 4D étant une vue de dessus).

Comme représenté sur la figure 4E, on réalise une épitaxie de silicium de la couche 6, de manière à ce que la portion restante de la couche de SiGe 104 soit complètement entourée par le silicium de la couche active 6.

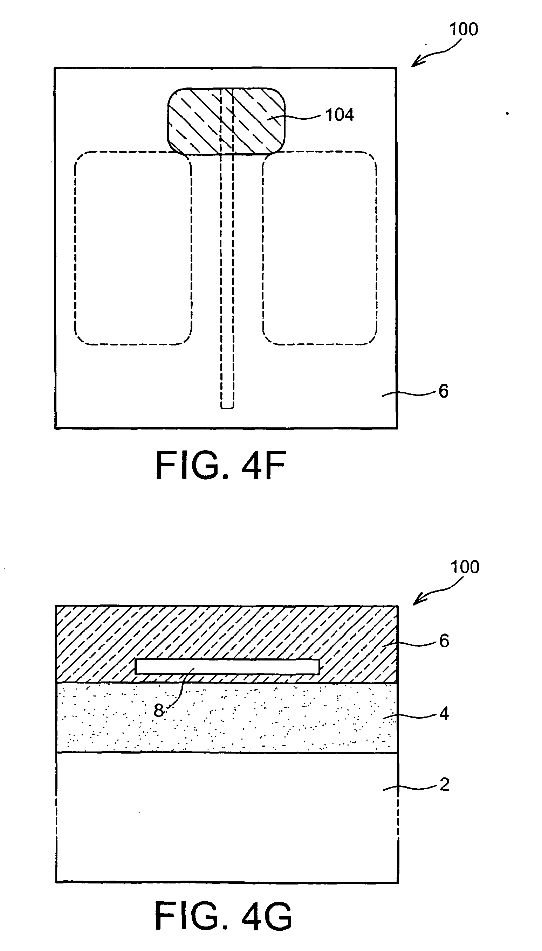

On réalise ensuite par gravure une ouverture dans la couche active 6 permettant d'accéder à la couche 104 de SiGe (figure 4F). On grave ensuite de manière sélective la portion de SiGe de la couche 104 à travers l'ouverture réalisée précédemment, formant ainsi une cavité de vide 8 dans la couche active 6 de silicium (figure 4G).

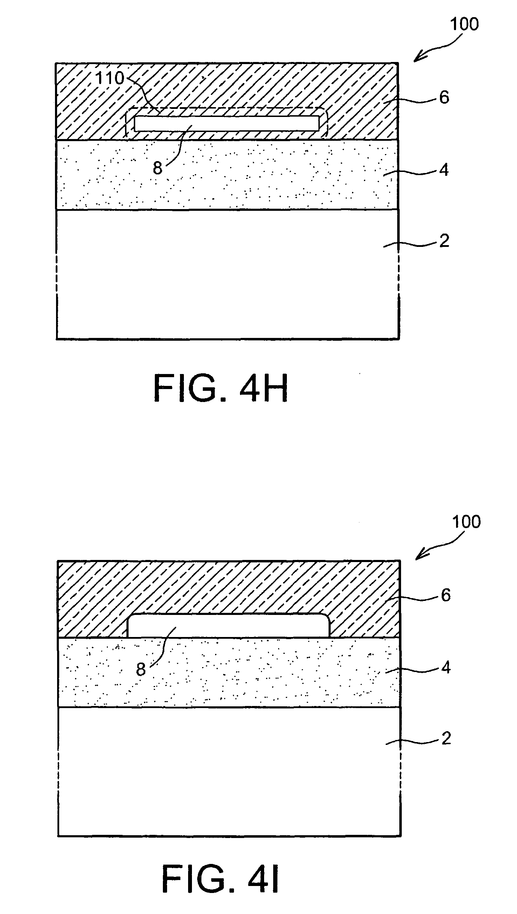

On réalise ensuite une oxydation du silicium des parois 110 de la cavité 8 (figure 4H). Cette oxydation est au moins réalisée telle que la portion de silicium de la couche active 6 se trouvant entre la cavité 8 et la couche d'oxyde 4 soit complètement oxydée.

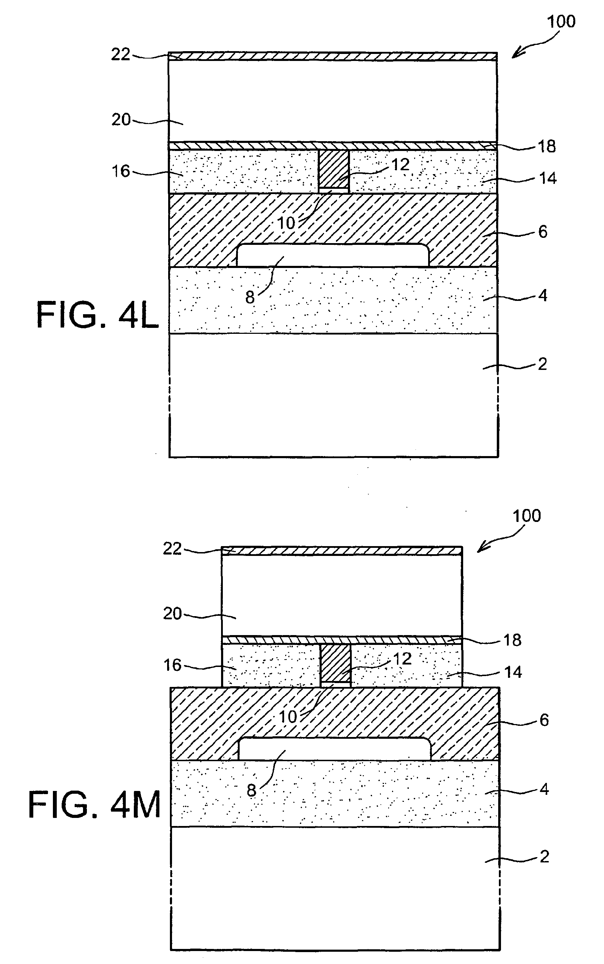

Comme représenté sur la figure 4I, l'oxyde de silicium 110 formé dans la cavité 8 est supprimé par gravure sélective par rapport au silicium de la couche active 6. On forme ainsi la cavité 8. On voit sur la figure 4I qu'une paroi de la cavité 8 est formée par une partie de la couche diélectrique 4.

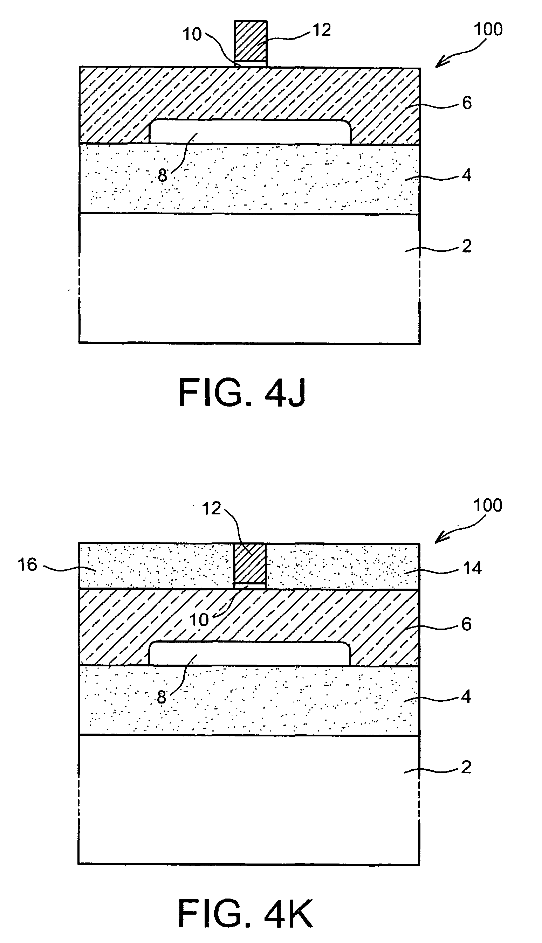

Comme représenté sur la figure 4J, on réalise ensuite un transistor MOS comportant une zone active comprenant une zone de source, une zone de drain et un canal réalisés dans la couche active 6. Le canal de ce transistor MOS est réalisé au-dessus de la cavité 8. Un diélectrique de grille 10 ainsi qu'une grille 12 sont réalisés sur le canal du transistor.

On dépose ensuite une couche diélectrique sur la couche active 6 et sur la grille 12. Une planarisation de cette couche diélectrique est ensuite mise en oeuvre, avec arrêt au niveau de la grille 12, tel que la surface de cette couche diélectrique soit au niveau de la face supérieure de la grille 12. Ainsi, la couche diélectrique forme, de part et d'autre de l'empilement de grille, des portions diélectriques 14 et 16 (figure 4K).

Dans une variante, la couche à base de diélectrique peut être remplacée par une couche à base de résine, formant ainsi des portions de résine de part et d'autre de la grille 12, remplaçant les portions diélectriques 14 et 16.

Sur la figure 4L, on réalise ensuite des dépôts successifs de la couche conductrice 18 formant l'électrode inférieure de l'empilement piézoélectrique, de la couche piézoélectrique 20 et de la couche conductrice 22 formant l'électrode supérieure de l'empilement piézoélectrique.

On grave ensuite de manière anisotrope successivement des parties de l'empilement piézoélectrique 18, 20 et 22 et des portions diélectriques 14 et 16 ne se trouvant pas au-dessus de la cavité 8 (figure 4M).

Dans le cas où des portions de résine sont disposées de part et d'autre de la grille 12, ces portions de résine peuvent être retirées, formant ainsi des zones de vide sous l'empilement piézoélectrique 18, 20 et 22. Ces zones de vide peuvent alors être remplies par un autre matériau.

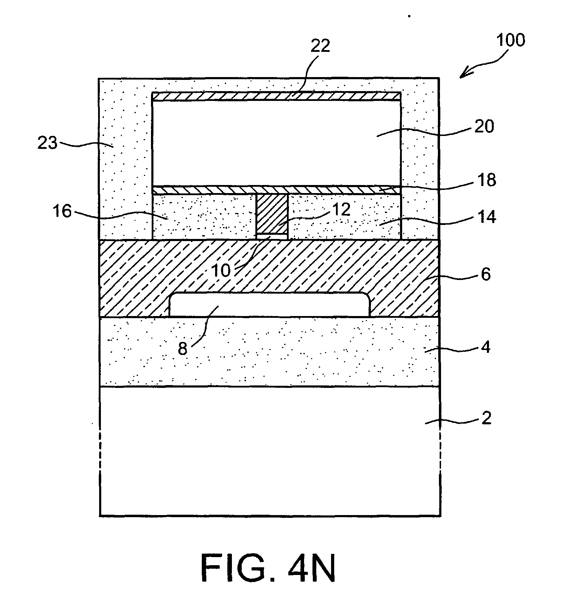

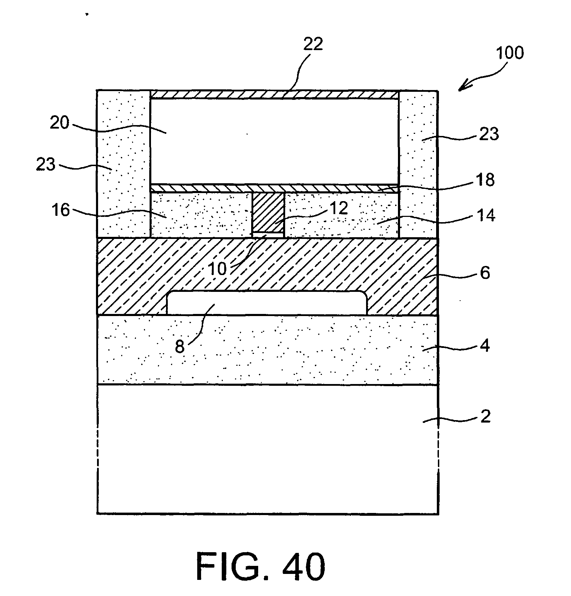

Enfin, comme représenté sur les figures 4N et 4O, on réalise un dépôt de diélectrique 23 autour des emplacements gravés précédemment et sur la couche conductrice 22, puis on réalise une planarisation de la surface supérieure de la structure formée avec arrêt au niveau de la couche conductrice 22.

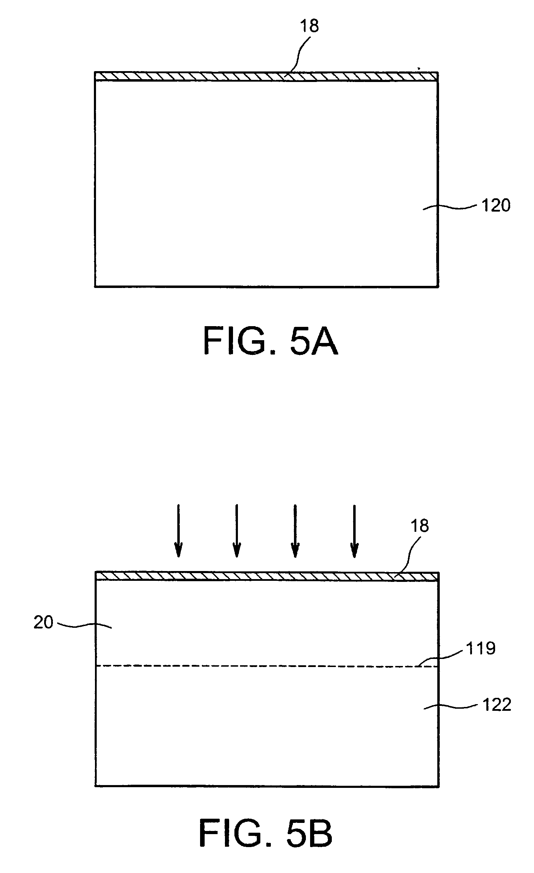

On se réfère maintenant aux figures 5A à 5D pour décrire des étapes d'un procédé de réalisation du dispositif semi-conducteur 100 selon un second mode de réalisation.

Comme pour le premier mode de réalisation, on met en oeuvre les étapes représentées sur les figures 4A à 4K de manière à former une structure comportant le substrat 2, la couche diélectrique 4, la couche active 6, la cavité 8, le diélectrique de grille 10, la grille 12 et les portions diélectriques 14 et 16.

Comme représenté sur la figure 5A, on recouvre un substrat 120 à base d'un matériau piézoélectrique monocristallin de la couche électriquement conductrice 18.

On réalise ensuite une implantation ionique dans le substrat 120 à travers la couche conductrice 18, puis un recuit permettant la diffusion des ions implantés, formant une délimitation 119 séparant le substrat 120 en deux parties 122 et 20 (figure 5B). La partie 20 du substrat 120 en contact avec la couche conductrice 18 forme la couche mince qui sera reportée sur le transistor. On sépare ensuite l'une de l'autre les parties 122 et 20. On a ainsi la couche mince 20, par exemple d'épaisseur égale à environ 100 nm, obtenue par un procédé de type Smart-Cut™ recouverte de la couche conductrice 18, par exemple d'épaisseur égale à environ 10 nm.

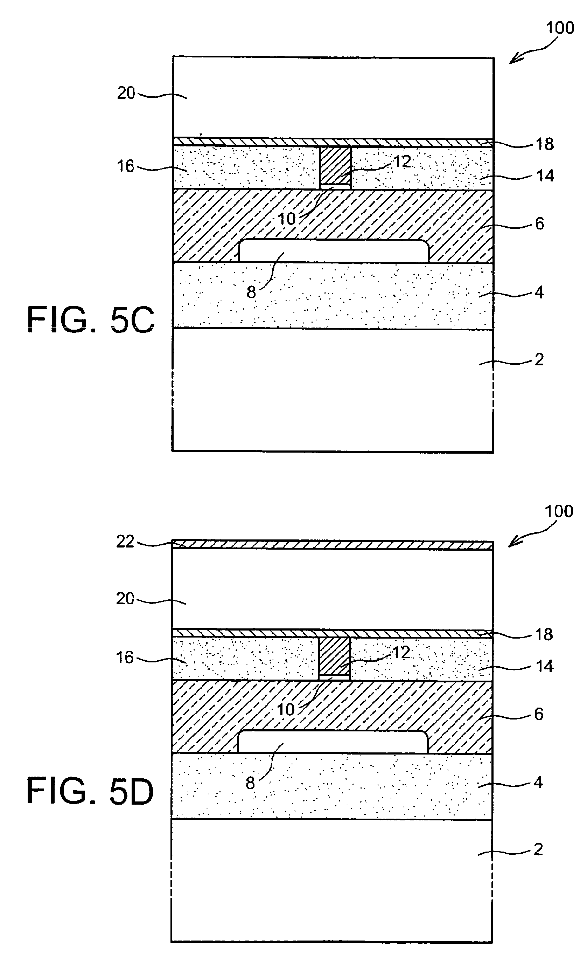

Sur la figure 5C, on colle ensuite par adhésion moléculaire la couche mince piézoélectrique 20, par l'intermédiaire de la couche conductrice 18, sur la grille 12 et les portions diélectriques 14 et 16.

La couche conductrice 22 est ensuite déposée sur la couche piézoélectrique 20, formant l'électrode supérieure de l'empilement de grille du dispositif 100 (figure 5D).

Le dispositif 100 est ensuite terminé comme pour le premier mode de réalisation par les étapes représentées sur les figures 4M à 4O. Dans ce second mode de réalisation, la surface de la couche 18 servant d'électrode inférieure est plane afin que le mécanisme de collage moléculaire puisse être utilisable pour une couche piézoélectrique à base d'un matériau monocristallin.

## Revendications

**1.** Dispositif semi-conducteur (100, 200, 300) comportant au moins :

- un substrat (2, 4, 6),
- un transistor comprenant au moins une région de source, une région de drain, un canal et une grille (12),
- une couche (20) plane à base d'au moins un matériau piézoélectrique, reposant au moins sur la grille (12) sans être directement disposée sur les régions de source et de drain, et apte à induire au moins une contrainte mécanique sur le canal du transistor selon une direction sensiblement perpendiculaire au plan d'une face de la couche piézoélectrique (20) se trouvant du côté de la grille (12),

la couche piézoélectrique étant disposée entre deux électrodes de polarisation (12, 18, 22), l'une des deux électrodes de polarisation (22) étant formée par une première couche à base d'au moins un matériau électriquement conducteur tel que la couche piézoélectrique (20) soit disposée entre cette première couche conductrice (22) et la grille (12) du transistor.

**2.** Dispositif semi-conducteur (100, 200, 300) selon la revendication 1, la première couche conductrice (22) étant plane.

**3.** Dispositif semi-conducteur (100, 200, 300) selon l'une des revendications précédentes, les dimensions des faces des électrodes (12, 18, 22) en contact avec la couche piézoélectrique (20) étant supérieures ou égales aux dimensions des faces de la couche piézoélectrique (20) en contact avec les électrodes (12, 18, 22).

**4.** Dispositif semi-conducteur selon l'une des revendications précédentes, l'autre des deux électrodes de polarisation est formée par la grille (12) du transistor ou par une seconde couche à base d'au moins un matériau électriquement conducteur disposée entre la couche piézoélectrique (20) et la grille (12) du transistor.

**5.** Dispositif semi-conducteur (100, 200, 300) selon la revendication 4, comportant en outre une couche diélectrique disposée entre la grille (12) et la seconde couche à base de matériau conducteur (18).

**6.** Dispositif semi-conducteur (100, 200, 300) selon l'une des revendications précédentes, la première couche conductrice (22) et/ou, lorsque le dispositif (100, 200, 300) comporte une seconde couche conductrice (18), la seconde couche conductrice (18) étant sensiblement planes et parallèles à la couche piézoélectrique (20).

**7.** Dispositif semi-conducteur (100, 200, 300) selon l'une des revendications précédentes, le substrat comportant une couche (2) à base d'un matériau semi-conducteur, sur laquelle sont empilées une couche diélectrique (4) et une couche active (6) à base d'un matériau semi-conducteur.

**8.** Dispositif semi-conducteur (100, 200, 300) selon l'une des revendications précédentes, le substrat (2, 4, 6) comportant une cavité (8) formée au moins sous le canal du transistor.

9. Dispositif semi-conducteur (100, 200, 300) selon la revendication 8, la cavité (8) étant remplie d'au moins un matériau dont la raideur est inférieure à celle du matériau du substrat (6).

10. Dispositif semi-conducteur (100, 200, 300) selon l'une des revendications précédentes, comportant en outre au moins une portion (14) à base d'au moins un matériau diélectrique disposée sur le substrat (2, 4, 6) et à côté de la grille (12), recouvrant au moins une partie de la zone de source ou de drain, la couche piézoélectrique (20) reposant également sur cette portion diélectrique (14).

11. Dispositif semi-conducteur (100, 200) selon les revendications 10, comportant en outre une seconde portion (16) d'au moins un matériau diélectrique disposée sur le substrat (2, 4, 6) et à côté de la grille (12), sur laquelle repose la couche piézoélectrique (20), les zones de source et de drain étant au moins recouvertes en partie par les portions diélectriques (14, 16).

12. Dispositif semi-conducteur (100, 200, 300) selon l'une des revendications 10 ou 11, la raideur du matériau de la grille (12) étant supérieure à la raideur du matériau de la ou des portions diélectriques (14, 16).

13. Dispositif semi-conducteur (100, 200, 300) selon l'une des revendications 10 à 12, le rapport de la raideur du matériau de la grille (12) sur la raideur du matériau de la ou des portions diélectriques (14, 16) étant supérieure à 1, et par exemple compris entre environ 2 et 5.

14. Dispositif semi-conducteur (100, 200, 300) selon l'une des revendications 10 à 13, lorsque la couche piézoélectrique (20) est disposée entre deux couches conductrices (18, 22), la raideur du matériau des couches conductrices (18, 22) est supérieure à la raideur du matériau des portions diélectriques (14, 16).

15. Dispositif semi-conducteur (100) selon l'une des revendications précédentes, la couche piézoélectrique (20) étant symétrique par rapport à un premier plan sensiblement perpendiculaire au plan de la face de la couche piézoélectrique (20) se trouvant du côté de la grille (12), la grille (12) étant symétrique par rapport à un second plan sensiblement perpendiculaire audit plan de la face de la couche piézoélectrique (20) se trouvant du côté de la grille (12), les premier et second plans étant superposés ou décalés l'un par rapport à l'autre.

16. Procédé de réalisation d'un dispositif semi-conducteur (100, 200, 300) comportant au moins les étapes de :

- réalisation d'un transistor comprenant au moins une région de source, une région de drain, un canal et une grille (12) sur un substrat (2, 4, 6),
- dépôt d'une couche (20) plane à base d'au moins un matériau piézoélectrique au moins au-dessus de la grille (12) sans être directement disposée sur les régions de source et de drain, la couche piézoélectrique (20) étant apte à induire au moins une contrainte mécanique sur le canal du transistor selon une direction perpendiculaire au plan d'une face de la couche piézoélectrique (20) se trouvant du côté de la grille (12),
- dépôt d'une couche (22) à base d'au moins un matériau électriquement conducteur formant une première électrode de polarisation tel que la couche piézoélectrique (20) soit disposée entre cette couche conductrice (22) et la grille (12) du transistor,

la couche piézoélectrique (20) étant également disposée sur une seconde électrode de polarisation (12, 18).

17. Procédé selon la revendication 16, comportant en outre, entre l'étape de réalisation du transistor et l'étape de dépôt de la couche piézoélectrique (20), une étape de dépôt d'une autre couche (18) à base d'au moins un matériau électriquement conducteur au moins au-dessus de la grille (12), la couche piézoélectrique (20) étant ensuite déposée sur cette autre couche conductrice (18) formant la seconde électrode de polarisation.

18. Procédé selon la revendication 17, comportant en outre, avant l'étape de dépôt de l'autre couche (18) à base de matériau électriquement conducteur, une étape de dépôt d'une couche diélectrique sur la grille (12), ladite autre couche (18) à base de matériau électriquement conducteur étant déposée sur la couche diélectrique.

19. Procédé selon la revendication 16, comportant en outre, entre l'étape de réalisation du transistor et l'étape de dépôt de la couche piézoélectrique (20), une étape de réalisation de la couche piézoélectrique (20) et d'une autre couche (18) à base d'au moins un matériau électriquement conducteur par une implantation ionique dans un substrat (120) à base du matériau piézoélectrique comportant ladite autre couche conductrice (18) sur une de ses faces puis par une fracture au niveau de l'implantation réalisée dans le substrat (120), ladite autre couche conductrice (18) étant disposée contre la grille (12) lors de l'étape de dépôt de la couche piézoélectrique (20).

20. Procédé selon l'une des revendications 16 à 19, comportant en outre, avant l'étape de réalisation du transistor, une étape de réalisation d'une cavité (8) dans le substrat (2, 4, 6) destinée à être disposée sous le canal du transistor.

21. Procédé selon la revendication 20, la réalisation de la cavité (8) étant obtenue par la mise en oeuvre des étapes suivantes :

   - dépôt d'une première couche (104) sur le substrat (2, 4, 6), et d'une seconde couche (106) à base d'un matériau similaire à celui du substrat (6) sur la première couche (104), la première couche (104) étant à base d'un matériau pouvant être gravé sélectivement par rapport aux matériaux du substrat (6) et de la seconde couche (106),
   - gravure anisotrope des première et seconde couches (104, 106) tel que le motif formé par la portion restante de la première couche (104) soit sensiblement similaire au motif de la cavité (8), avec arrêt au niveau du substrat (2, 4, 6),
   - épitaxie du matériau du substrat (6) tel que le substrat et la seconde couche (106) forme une couche active (6) du substrat (2, 4, 6) encapsulant la portion restante de la première couche (104),
   - réalisation d'une ouverture (104) dans la couche active (6) pour accéder à la portion restante de la première couche (104),
   - gravure sélective du matériau de la portion restante de la première couche (104), formant la cavité (8).

22. Procédé selon la revendication 21, comportant en outre, Lorsque le substrat (2, 4, 6) est du type semi-conducteur (6) sur isolant (4), après l'étape de gravure sélective du matériau de la portion restante de la première couche (104), les étapes supplémentaires de :

   - oxydation des parois (110) de la cavité (8),
   - gravure sélective de l'oxyde formée au niveau des parois (110) tel qu'une partie de l'isolant (4) du substrat (2, 4, 6) forme une paroi de la cavité (8).

23. Procédé selon l'une des revendications 20 à 22, comportant en outre, après la réalisation de la cavité (8), une étape de remplissage de la cavité (8) par au moins un matériau dont la raideur est inférieure à celle du matériau du substrat (6).

24. Procédé selon l'une des revendications 16 à 23, comportant en outre, entre l'étape de réalisation du transistor et l'étape de dépôt de la couche piézoélectrique (20), une étape de dépôt d'au moins une portion (14) à base d'au moins un matériau diélectrique sur le substrat (2, 4, 6), recouvrant au moins une partie de la zone de source ou de drain, à côté de la grille (12), la couche piézoélectrique (20) étant ensuite déposée au-dessus de la portion diélectrique (14), ou une étape de dépôt d'au moins une portion à base d'une résine, et une étape de retrait de cette portion de résine après le dépôt de la couche piézoélectrique au-dessus de la grille (12) et de la portion de résine.

## Claims

1. Semiconductor device (100, 200, 300) comprising at least:

   - a substrate (2, 4, 6),
   - a transistor comprising at least one source region, one drain region, one channel and one gate (12),
   - a planar layer (20) based on at least one piezoelectric material, resting at least on the gate (12) without being arranged directly on the source and drain regions, and capable of inducing at least a mechanical strain on the transistor channel according to a direction that is substantially perpendicular to the plane of a face of the piezoelectric layer (20) situated on the gate (12) side,

   the piezoelectric layer being arranged between two biasing electrodes (12, 18, 22), one of the two biasing electrodes (22) being formed by a first layer based on at least one electrically conductive material such that the piezoelectric layer (20) is arranged between this first conductive layer (22) and the gate (12) of the transistor.

2. Semiconductor device (100, 200, 300) according to claim 1, wherein the first conducting layer (22) is planar.

3. Semiconductor device (100, 200, 300) according to one of previous claims, wherein the dimensions of the faces of the electrodes (12, 18, 22) in contact with the piezoelectric layer (20) are greater than or equal to the dimensions of the faces of the piezoelectric layer (20) in contact with the electrodes (12, 18, 22).

4. Semiconductor device according to one of previous claims, wherein the other one of the two biasing electrodes is formed by the transistor gate (12) or by a second layer based one at least one electrically conductive material arranged between the piezoelectric layer (20) and the gate (12) of the transistor.

5. Semiconductor device (100, 200, 300) according to claim 4, further comprising a dielectric layer arranged between the gate (12) and the second layer based on a conductive material (18).

6. Semiconductor device (100, 200, 300) according to one of previous claims, wherein the first conductive layer (22) and/or, when the device (100, 200, 300) comprises a second conductive layer (18), the second conductive layer (18) are substantially planar and parallel to the piezoelectric layer (20).

7. Semiconductor device (100, 200, 300) according to one of previous claims, wherein the substrate comprises a layer (2) based on a semiconductor material, upon which are stacked a dielectric layer (4) and an active layer (6) based on a semiconductor material.

8. Semiconductor device (100, 200, 300) according to one of previous claims, wherein the substrate (2, 4, 6) comprises a cavity (8) formed at least beneath the transistor channel.

9. Semiconductor device (100, 200, 300) according to claim 8, wherein the cavity (8) is filled with at least one material the stiffness of which being less than that of the substrate material (6).

10. Semiconductor device (100, 200, 300) according to one of previous claims, further comprising at least one portion (14) based on at least one dielectric material arranged on the substrate (2, 4, 6) and beside the gate (12), covering at least one portion of the source or drain region, while the piezoelectric layer (20) also rests on this dielectric portion (14).

11. Semiconductor device (100, 200) according to claim 10, further comprising a second portion (16) of at least one dielectric material arranged on the substrate (2, 4, 6) and beside the gate (12), onto which the piezoelectric layer (20) rests, the drain and source regions being at least partially covered by the dielectric portions (14, 16).

12. Semiconductor device (100, 200, 300) according to one of claims 10 or 11, wherein the stiffness of the gate (12) material is greater than the stiffness of the material of the dielectric portion or portions (14, 16).

13. Semiconductor device (100, 200, 300) according to one of claims 10 to 12, wherein the ratio of the stiffness of the gate (12) material to the stiffness of the material of the dielectric portion or portions (14, 16) is greater than 1, and, for example, between approximately 2 and 5.

14. Semiconductor device (100, 200, 300) according to one of claims 10 to 13, wherein, when the piezoelectric layer (20) is arranged between two conductive layers (18, 22), the stiffness of the material of the conductive layers (18, 22) is greater than that of the stiffness of the material of the dielectric portions (14, 16).

15. Semiconductor device (100) according to one of previous claims, wherein the piezoelectric layer (20) is symmetrical in relation to a first plane, which is substantially perpendicular to the plane of the face of the piezoelectric layer (20) situated on the gate (12) side, while the gate (12) is symmetrical with respect to a second plane which is substantially perpendicular to said plane of the face of the piezoelectric layer (20) situated on the gate (12) side, the first and second planes being superimposed or shifted one relative to the other.

16. Method of producing a semiconductor device (100, 200, 300), comprising at least the following steps:

    - producing a transistor comprising at least one source region, one drain region, one channel and one gate (12) on a substrate (2, 4, 6),
    - depositing a planar layer (20) based on at least one piezoelectric material at least over the gate (12) without being arranged directly on the source and drain regions, the piezoelectric layer (20) being capable of inducing at least one mechanical strain on the transistor channel according to a direction which is perpendicular to the plane of a face of the piezoelectric layer (20) situated on the gate (12) side,
    - depositing a layer (22) based on at least one electrically conductive layer forming a first biasing electrode, such that the piezoelectric layer (20) is arranged between this conductive layer (22) and the transistor gate (12),

    the piezoelectric layer (20) also being arranged on a second biasing electrode (12, 18).

17. Method according to claim 16, further comprising, between the step of producing the transistor and the step of depositing the piezoelectric layer (20), a step for depositing another layer (18) based on at least one electrically conductive material, at least above the gate (12), while the piezoelectric layer (20) is then deposited on this other conductive layer (18) forming the second biasing electrode.

18. Method according to claim 17, further comprising, prior to the step of depositing the other layer (18) based on an electrically conductive material, a step of depositing a dielectric layer on the gate (12), said other layer (18) based an electrically conductive material being arranged on the dielectric layer.

19. Method according to claim 16, further comprising, between the step of producing the transistor and the step of depositing the piezoelectric layer (20), a step of producing the piezoelectric layer (20) and another layer (18) based on at least one electrically conductive material, via ion implantation on a substrate (120) based on said piezoelectric material comprising said other conductive layer (18) on one of the faces thereof, and by cleaving in the vicinity of the implantation made in the substrate (120), said other conductive layer (18) being arranged against the gate (12) during the step of depositing the piezoelectric layer (20).

20. Method according to one of claims 16 to 19, further comprising, prior to the step of producing the transistor, a step of producing a cavity (8) in the substrate (2, 4, 6), which is intended to be arranged beneath the transistor channel.

21. Method according to claim 20, wherein the cavity (8) is made by implementing the following steps:

- deposition of a first layer (104) onto the substrate (2, 4, 6) and of a second layer (106) based on a material similar to that of the substrate (6), onto the first layer (104), the first layer (104) being based on a material capable of being etched selectively with respect to the materials of the substrate (6) and the second layer (106),
- anisotropic etching of the first and second layers (104, 106), such that the pattern formed by the remaining portion of the first layer (104) is substantially similar to the pattern of the cavity (8), and which stops at the substrate (2, 4, 6) level,
- epitaxy of the substrate material (6) such that the substrate and the second layer (106) form an active layer (6) of the substrate (2, 4, 6) which encapsulates the remaining portion of the first layer (104),
- making of an opening (104) in the active layer (6) for accessing the remaining portion of the first layer (104),
- selective etching of the material of the remaining portion of the first layer (104), thus forming the cavity (8).

22. Method according to claim 21, further comprising, when the substrate (2, 4, 6) is of the semiconductor (6) on insulator (4) type, and after the step of selectively etching the material of the remaining portion of the first layer (104), the additional steps of:

- oxidation of the cavity (8) walls (110),
- selective etching of the oxide formed on the walls (110), such that a portion of the substrate (2, 4, 6) insulator (4) forms a wall of the cavity (8).

23. Method according to one of claims 20 to 22, further comprising, after making the cavity (8), a step of filling the cavity (8) with at least one material the stiffness of which is less than that of the substrate material (6).

24. Method according to one of claims 16 to 23, further comprising, between the step of producing the transistor and the step of depositing the piezoelectric layer (20), a step for depositing at least one portion (14) based on a dielectric material onto the substrate (2, 4, 6), which covers at least a portion of the source or drain region, next to the gate (12), the piezoelectric layer (20) then being deposited over the dielectric portion (14), or a step of depositing at least one resin-based portion, and a step of removing this resin portion, after the piezoelectric layer has been deposited over the gate (12) and the resin portion.

**Patentansprüche**

1. Halbleitervorrichtung (100, 200, 300), wenigstens umfassend:

- ein Substrat (2, 4, 6),
- einen Transistor mit wenigstens einer Sourcezone, einer Drainzone, einem Kanal und einem Gate (12),
- eine plane Schicht (20) auf Basis wenigstens eines piezoelektrischen Materials, wenigstens auf dem Gate (12) ruhend, ohne direkt über den Source- und Drainzonen angeordnet zu sein, und fähig, auf den Kanal des Transistors eine mechanische Spannung gemäß einer Richtung auszuüben, die im Wesentlichen senkrecht ist zu der Ebene einer auf der Seite des Gates (12) befindlichen Fläche der piezoelektrischen Schicht (20),

wobei die piezoelektrische Schicht zwischen zwei Polarisationselektroden (12, 18, 22) angeordnet ist und dabei eine der beiden Polarisationselektroden (22) durch eine erste Schicht auf der Basis von wenigstens einem elektrisch leitfähigen Material gebildet wird, so dass die piezoelektrische Schicht (20) sich zwischen dieser ersten leitfähigen Schicht (22) und dem Gate (12) des Transistors befindet.

2. Halbleitervorrichtung (100, 200, 300) nach Anspruch 1, wobei die erste leitfähige Schicht (22) plan ist.

3. Halbleitervorrichtung (100, 200, 300) nach einem der vorhergehenden Ansprüche, wobei die Dimensionen der Flächen der Elektroden (12, 18, 22), in Kontakt mit der piezoelektrischen Schicht (20), größer sind oder gleich groß sind wie die Dimensionen der in Kontakt mit den Elektroden (12, 18, 22) befindlichen Flächen der piezoelektrischen Schicht (20).

4. Halbleitervorrichtung nach einem der vorhergehenden Ansprüche, wobei die andere der beiden Polarisationselektroden durch das Gate (12) des Transistors oder durch eine zweite Schicht auf der Basis wenigstens eines zwischen der piezoelektrischen Schicht (20) und dem Gate (12) des Transistors abgeschiedenen elektrisch leitfähigen Materials gebildet wird.

5. Halbleitervorrichtung (100, 200, 300) nach Anspruch 4, mit außerdem einer dielektrischen Schicht, angeordnet zwischen dem Gate (12) und der zweiten Schicht auf Basis eines leitfähigen Materials (18).

6. Halbleitervorrichtung (100, 200, 300) nach einem der vorhergehenden Ansprüche, wobei die erste leitfähige Schicht (22) und/oder, wenn die Vorrichtung (100, 200, 300) eine zweite leitfähige Schicht (18) umfasst, die zweite leitfähige Schicht (18) im Wesentlichen plan und parallel zu der piezoelektrischen Schicht (20) ist.

7. Halbleitervorrichtung (100, 200, 300) nach einem der vorhergehenden Ansprüche, wobei das Substrat eine Schicht (2) auf Basis eines Halbleitermaterials umfasst, auf der eine dielektrische Schicht (4) und eine aktive Schicht (6) auf Basis eines Halbleitermaterials gestapelt sind.

8. Halbleitervorrichtung (100, 200, 300) nach einem der vorhergehenden Ansprüche, wobei das Substrat (2, 4, 6) eine wenigstens unter dem Transistorkanal ausgebildete Kavität (8) umfasst.

9. Halbleitervorrichtung (100, 200, 300) nach Anspruch 8, wobei die Kavität (8) mit wenigstens einem Material gefüllt ist, dessen Steifheit niedriger ist als die des Materials des Substrats (6).

10. Halbleitervorrichtung (100, 200, 300) nach einem der vorhergehenden Ansprüche, die außerdem wenigstens einen Teil bzw. ein Element (14) auf Basis wenigstens eines dielektrischen Materials umfasst, angeordnet auf dem Substrat (2, 4, 6) und neben dem Gate (12), dabei wenigstens einen Teil der Source- oder Drainzone überdeckend, wobei die piezoelektrische Schicht (20) ebenfalls auf diesem dielektrischen Teil bzw. Element (14) ruht.

11. Halbleitervorrichtung (100, 200, 300) nach Anspruch 10, die außerdem wenigstens ein zweites Element (16) aus wenigstens einem dielektrischen Material umfasst, angeordnet auf dem Substrat (2, 4, 6) und neben dem Gate (12), auf dem die piezoelektrische Schicht (20) ruht, wobei die Source- und Drainzonen wenigstens teilweise von den dielektrischen Teilen bzw. Elementen (14, 16) überdeckt sind.

12. Halbleitervorrichtung (100, 200, 300) nach einem der Ansprüche 10 oder 11, wobei die Steifheit des Materials des Gates (12) höher ist als die Steifheit des Materials des/der dielektrischen Elements/Elemente (14, 16).

13. Halbleitervorrichtung (100, 200, 300) nach einem der Ansprüche 10 bis 12, wobei das Verhältnis von Steifheit des Materials des Gates (12) zu Steifheit des Materials des/der dielektrischen Elements/Elemente (14, 16) höher ist als 1, zum Beispiel enthalten zwischen 2 und 5.

14. Halbleitervorrichtung (100, 200, 300) nach einem der Ansprüche 10 bis 13, bei der, wenn die piezoelektrische Schicht (20) zwischen zwei leitfähigen Schichten (18, 22) angeordnet ist, die Steifheit des Materials der leitfähigen Schichten (18, 22) höher ist als die Steifheit des Materials der dielektrischen Teile bzw. Elemente (14, 16).

15. Halbleitervorrichtung (100) nach einem der vorangehenden Ansprüche, wobei die piezoelektrische Schicht (20) symmetrisch ist in Bezug auf eine erste Ebene, die im Wesentlichen senkrecht ist zu der Ebene der auf der Seite des Gates (12) befindlichen Fläche der piezoelektrischen Schicht (20), wobei das Gate symmetrisch ist in Bezug auf eine zweite Ebene, die im Wesentlichen senkrecht ist zu der genannten Ebene der auf der Seite des Gates (12) befindlichen Fläche der piezoelektrischen Schicht (20), wobei die erste und die zweite Ebene übereinander liegen oder gegeneinander versetzt sind.

16. Verfahren zur Herstellung einer Halbleitervorrichtung (100, 200, 300) mit wenigstens den folgenden Schritten:

> - Herstellung eines Transistors mit wenigstens einer Sourcezone, einer Drainzone, einem Kanal und einem Gate (12) auf einem Substrat (2, 4, 6),
> - Abscheidung einer planen Schicht (20) auf Basis wenigstens eines piezoelektrischen Materials, wenigstens auf dem Gate (12) ruhend, ohne direkt über den Source- und Drainzonen angeordnet zu sein, und fähig, auf den Kanal des Transistors eine mechanische Spannung gemäß einer Richtung auszuüben, die im Wesentlichen senkrecht ist zu der Ebene einer auf der Seite des Gates (12) befindlichen Fläche der piezoelektrischen Schicht (20),
- Abscheidung einer Schicht (22) auf Basis wenigstens eines elektrisch leitfähigen Materials, eine erste Polarisationselektrode bildend, derart dass die piezoelektrische Schicht (20) zwischen dieser leitfähigen Schicht (22) und dem Gate (12) des Transistors angeordnet ist,

wobei die piezoelektrische Schicht (20) ebenfalls auf einer zweiten Polarisationselektrode (12, 18) abgeschieden ist.

17. Verfahren nach Anspruch 16, außerdem umfassend
- zwischen dem Hersteflungsschritt des Transistors und dem Abscheidungsschritt der piezoelektrischen Schicht (20) -, einen Schritt zur Abscheidung einer anderen Schicht (18) auf Basis wenigstens eines elektrisch leitfähigen Materials wenigstens über dem Gate (12), wobei die piezoelektrische Schicht (20) anschließend auf dieser leitfähigen, die zweite Polarisationselektrode bildenden Schicht (18) abgeschieden wird.

18. Verfahren nach Anspruch 17, außerdem umfassend, vor dem Abscheidungsschritt der anderen Schicht (18) auf Basis eines elektrisch leitfähigen Materials, einen Schritt zu Abscheidung einer dielektrischen Schicht auf dem Gate (12), wobei die genannte andere Schicht (18) auf Basis eines elektrisch leitfähigen Materials auf der dielektrischen Schicht abgeschieden wird.

19. Verfahren nach Anspruch 16, außerdem umfassend, zwischen dem Schritt zur Herstellung des Transistors und dem Schritt zur Abscheidung der piezoelektrischen Schicht (20), einen Schritt zur Herstellung der piezoelektrischen Schicht (20) und einer anderen Schicht (18) auf Basis wenigstens eines elektrisch leitfähigen Materials durch Ionenimplantation in einem Substrat (120) auf Basis des piezoelektrischen Materials mit der genannten anderen leitfähigen Schicht (18) auf einer seiner Flächen, dann durch einen Bruch in Höhe der in dem Substrat (120) realisierten Implantation, wobei die genannte andere leitfähige Schicht (18) während des Abscheidungsschritts der piezoelektrischen Schicht (20) am Gate (12) angeordnet ist.

20. Verfahren nach einem der Ansprüche 16 bis 19, außerdem umfassend, vor dem Schritt zu Herstellung des Transistors, einen Schritt zur Realisierung einer Kavität (8) unter dem Transistorkanal in dem Substrat (2, 4, 6).

21. Verfahren nach Anspruch 20, wobei die Kavität (8) durch die folgenden Schritte realisiert wird:

- Abscheiden einer ersten Schicht (104) auf dem Substrat (2, 4, 6) und einer zweiten Schicht (106) auf der Basis eines dem des Substrats (6) ähnlichen Materials auf der ersten Schicht (104), wobei die erste Schicht (104) aus einem Material ist, das in Bezug auf die Materialien des Substrats (6) und der zweiten Schicht (106) selektiv geätzt werden kann,
- anisotropes Ätzen der ersten und der zweiten Schicht (104, 106) - derartig dass das durch den restlichen Teil der ersten Schicht (104) gebildete Muster im Wesentlichen dem Muster der Kavität (8) entspricht -, mit Stopp auf dem Niveau des Substrats (2, 4, 6),
- Expitaxieren des Materials des Substrats (6), derartig dass das Substrat und die zweite Schicht (106) eine den restlichen Teil der ersten Schicht (104) einkapselnde aktive Schicht (6) des Substrats (2, 4, 6) bildet,
- Realisieren einer Öffnung (104) in der aktiven Schicht (6) als Zugang zu dem restlichen Teil der ersten Schicht (104),
- selektives Ätzen des Materials des restlichen Teils der ersten Schicht (104), um die Kavität (8) auszubilden.

22. Verfahren nach Anspruch 21, mit außerdem - nach dem Schritt der Selektivätzung des Materials des restlichen Teils der ersten Schicht (104) - folgenden zusätzlichen Schritten:

- Oxidieren der Wände (110) der Kavität (8),
- selektives Ätzen des in Höhe der Wände (110) gebildeten Oxids, so dass ein Teil des Isolators (4) des Substrats (2, 4, 6) eine Wand der Kavität (8) bildet.

23. Verfahren nach einem der Ansprüche 20 bis 22, mit außerdem - nach der Herstellung der Kavität (8) - einem Schritt zum Füllen der Kavität (8) mit wenigstens einem Material, dessen Steifheit niedriger ist als diejenige des Materials des Substrats (6).

24. Verfahren nach einem der Ansprüche 16 bis 23, mit außerdem - zwischen dem Schritt zur Herstellung des Transistors und dem Schritt zur Abscheidung der piezoelektrischen Schicht (20) - einem Schritt zur Abscheidung wenigstens eines Elements (14) auf der Basis wenigstens eines neben dem Gate (12) wenigstens einen Teil der Source- oder Drainzone überdeckenden dielektrischen Materials auf dem Substrat (2, 4, 6), wobei die piezoelektrische Schicht (20) anschließend auf dem dielektrischen Element (14) abgeschieden wird, oder einen Schritt zur Abscheidung wenigstens eines Elements auf der Basis eines Resists, und einen Schritt zur Beseitigung dieses Resist-Elements nach der Abscheidung der piezoelektrischen Schicht über dem Gate (12) und dem Resist-Element.

FIG. 1

FIG. 2

FIG. 3

FIG. 4A

100

106

104

6

4

2

## FIG. 4B

100

106

104

6

4

2

## FIG. 4C

100

106

6

## FIG. 4D

100

104

6

4

2

## FIG. 4E

100

104

6

## FIG. 4F

100

6

8

4

2

## FIG. 4G

FIG. 4H

FIG. 4I

FIG. 4J

FIG. 4K

FIG. 4L

FIG. 4M

FIG. 4N

FIG. 40

FIG. 5A

FIG. 5B

FIG. 5C

FIG. 5D

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5883419 A

- FR 2888990